(19) Europäisches Patentamt
European Patent Office
Office européen des brevets

(11) **EP 1 199 574 B1**

(12) **EUROPÄISCHE PATENTSCHRIFT**

(45) Veröffentlichungstag und Bekanntmachung des Hinweises auf die Patenterteilung:
**14.09.2005 Patentblatt 2005/37**

(51) Int Cl.⁷: **G01R 23/02**

(21) Anmeldenummer: **01118233.4**

(22) Anmeldetag: **30.07.2001**

(54) **Vorrichtung und Verfahren zur Frequenzmessung mit Integration der Signalphase**

Device and method for measuring frequency with signal phase integration

Dispositif et procédé de mesure de fréquence avec intégration de phase de signal

(84) Benannte Vertragsstaaten:
**DE FR GB**

(30) Priorität: **20.10.2000 DE 10052304**

(43) Veröffentlichungstag der Anmeldung:
**24.04.2002 Patentblatt 2002/17**

(73) Patentinhaber: **EADS Deutschland GmbH**
**81663 München (DE)**

(72) Erfinder: **Weidler, Gerhard, Dipl.-Ing.**
**89079 Ulm-Unterweiler (DE)**

(74) Vertreter: **Meel, Thomas**
**Patentassessor,**
**c/o Dornier GmbH**
**L H G**
**88039 Friedrichshafen (DE)**

(56) Entgegenhaltungen:
**EP-B- 0 373 802        EP-B- 0 609 707**
**US-A- 4 979 215**

**Beschreibung**

Die vorliegende Erfindung betrifft eine Vorrichtung und ein Verfahren zur Frequenzmessung mit Integration der Signalphase, wobei sowohl hochfrequente und pulsartige, als auch niederfrequente Frequenzen eines Signals digital gemessen werden können.

Die derzeit bekannten Vorrichtungen und Verfahren zur Frequenzmessung von hochfrequenten Signalen beruhen hauptsächlich auf der IFM-Frequenzmessung und der Frequenzmessung mit Zähler. Die IFM-Frequenzmessung bedingt eine aufwendige analoge Auswertung und Kompensation des Temperaturdrifts der Verzögerungsglieder und der HF-Komponente. Die Frequenzmessung mit einem Zähler beruht auf der Zeitmessung zwischen Nulldurchgängen des Signals, was die Auswertung bei sehr niederfrequenten, wie auch bei sehr hochfrequenten Signalen schwierig macht.

In der EP 0 609 707 B 1 ist eine Vorrichtung zur Frequenzmessung mit Integration der Signalphase beschrieben. Dabei wird mit einem ersten Phasenakkumulator, mit dem die Signalphase eines Signals, dessen Frequenz bestimmt werden soll, über einer vorbestimmten Anzahl von Zeitintervallen aufintegriert. Über eine zweite Anzahl von Zeitintervallen erfolgt eine weitere Aufintegration der Signalphase des zu vermessenden Signals in einem zweiten Phasenakkumulator, wobei die erste und zweite Anzahl von Zeitintervallen identisch ist. In einem Subtrahierer werden die Ausgangswerte von erstem und zweitem Phasenakkumulator subtrahiert. Der Ausgangswert des Subtrahierers wird einem Dividierer zugeführt und dort durch einen Faktor geteilt, der dem Quadrat der Anzahl der Zeitintervalle proportional ist. Der Ausgangswert des Dividierers nimmt einen Wert an, der proportional zu der zu messenden Frequenz ist.

Aufgabe der vorliegenden Erfindung ist es also, die vorgenannten Nachteile zu vermeiden und eine Vorrichtung bzw. ein Verfahren zu schaffen, mit der bzw. dem unter geringem Aufwand sowohl niederfrequente als auch hochfrequente Signale in ihrer Frequenz gemessen werden können. Im Rahmen der obigen Aufgabe besteht eine weitere besondere Aufgabe der vorliegenden Erfindung, eine Vorrichtung bzw. ein Verfahren zu schaffen, mit der bzw. dem auch pulsartige HF-Signale in ihrer Frequenz gemessen werden können.

Diese und weitere der nachfolgenden Beschreibung deutlich entnehmbaren Aufgaben werden von einer Vorrichtung zur Frequenzmessung mit Integration der Signalphase gelöst, die folgendes umfaßt: einen Phasenakkumulator, mit dem die Signalphase eines Signals, dessen Frequenz bestimmt werden soll, in vorbestimmten Zeitintervallen aufintegriert wird; ein erster Zwischenspeicher, der steuerbar ist, um nach einer vorbestimmten ersten Anzahl von Zeitintervallen einen ersten Ausgangswert des Phasenakkumulators zu übernehmen, und der weiterhin steuerbar ist, um nach einer vorbestimmten zweiten Anzahl von Zeitintervallen einen zweiten Ausgangswert des Phasenakkumulators zu übernehmen; ein zweiter Zwischenspeicher, der ausgebildet ist, um den ersten Ausgangswert des ersten Zwischen speichers zu übernehmen und mit einem ersten Faktor zu multiplizieren, der dem Quotient der zweiten Anzahl von Zeitintervallen und der ersten Anzahl von Zeitintervallen entspricht; ein Subtrahierer, der ausgebildet ist, um vom zweiten Ausgangswert den mit dem ersten Faktor multiplizierten ersten Ausgangswert zu subtrahieren; und ein Dividierer, der ausgebildet ist, den Ausgangswert des Subtrahierers durch einen zweiten Faktor zu teilen, der dem Produkt der ersten Anzahl von Zeitintervallen mit der Differenz der zweiten Anzahl von Zeitintervallen und der ersten Anzahl von Zeitintervallen entspricht, wobei der Ausgangswert des Dividierers einen Wert annimmt, der proportional zur zu messenden Frequenz ist.

Weiterhin wird erfindungsgemäß zur Lösung der obigen Aufgabe ein Verfahren zur Frequenzmessung mit Integration der Signalphase bereitgestellt, das die folgenden Schritte umfaßt: das Aufintegrieren in vorbestimmten Zeitintervallen der Signalphase eines Signals, dessen Frequenz bestimmt werden soll; das erste Zwischenspeichern der aufintegrierten Signalphase nach einer vorbestimmten ersten Anzahl von Zeitintervallen, um einen ersten Ausgangswert zu erhalten; das zweite Zwischenspeichern der aufintegrierten Signalphase nach einer vorbestimmten zweiten Anzahl von Zeitintervallen, um einen zweiten Ausgangswert zu erhalten; das Multiplizieren des ersten Ausgangswerts mit einem ersten Faktor, der dem Quotient der zweiten Anzahl von Zeitintervallen und der ersten Anzahl von Zeitintervallen entspricht; das Subtrahieren des mit dem ersten Faktor multiplizierten ersten Ausgangswerts vom zweiten Ausgangswert, um einen dritten Ausgangswert zu erhalten; und das Dividieren des dritten Ausgangswerts durch einen zweiten Faktor, der dem Produkt der ersten Anzahl von Zeitintervallen mit der Differenz der zweiten Anzahl von Zeitintervallen und der ersten Anzahl von Zeitintervallen entspricht, um einen vierten Ausgangswert zu erhalten; wobei der vierte Ausgangswert einen Wert annimmt, der proportional zur zu messenden Frequenz ist.

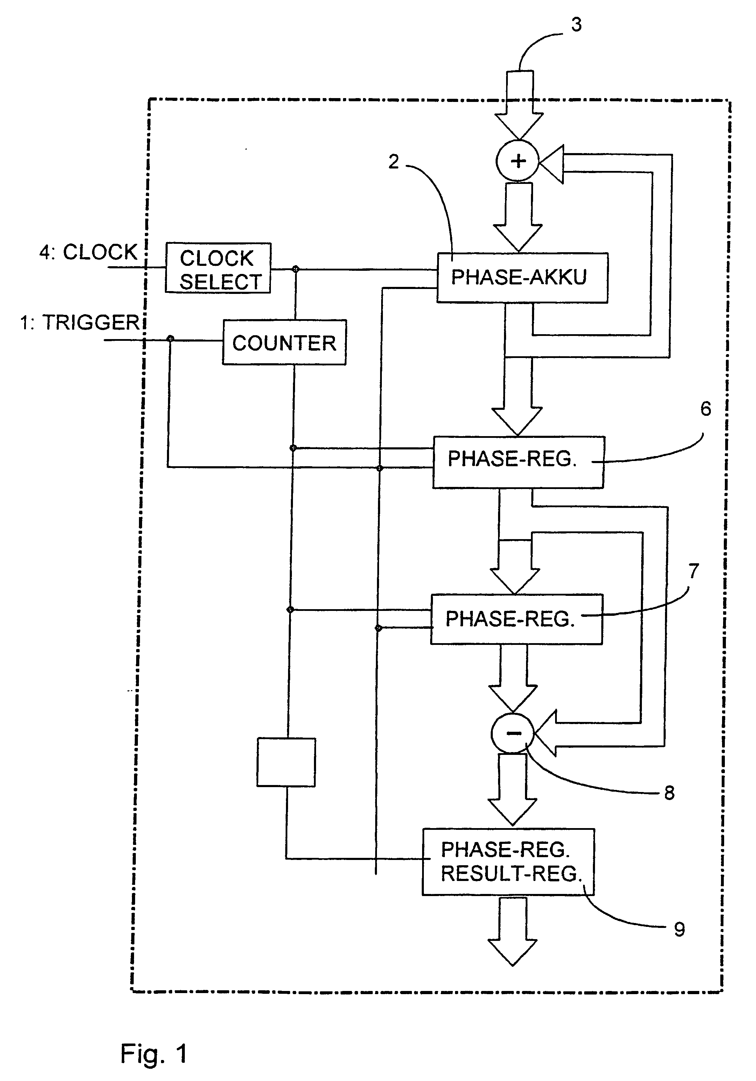

Weitere Merkmale und Vorteile sind der folgenden Beschreibung der Ausführungsbeispiele der erfindungsgemäßen Vorrichtung und des erfindungsgemäßen Verfahrens zur Frequenzmessung mit Integration der Signalphase unter Hinweis auf die beiliegende einzige Figur, die ein Blockschaltbild einer derzeit bevorzugten Schaltung zur Messung der Frequenz zeigt, zu entnehmen. Das in der Fig. 1 gezeigte Blockschaltbild ermöglicht eine Frequenzmessung, mit der sowohl hochfrequente und pulsartige, als auch niederfrequente Frequenzen digital erfaßt werden können.

Ein Problem bei hohen Signalfrequenzen und digitalen Messungen stellt hauptsächlich die Rechenzeit dar. Analoge Frequenzmeßverfahren bedingen einen hohen elektronischen, apparativen Aufwand. Die vorliegende Erfindung besteht in einem digitalen Verfahren, das leicht in Analog-/Digital-ASICS implementiert werden kann und daher ein breites Einsatzgebiet eröffnet. Mit der vorliegenden erfindungsgemäßen Vorrichtung bzw. mit dem erfindungsgemäßen Verfahren lassen sich auch kurze HF-Impulse genau messen. Die vorliegende Erfindung ermöglicht eine teils analoge und teils digitale Auswertung, die die oben beschriebenen Probleme der derzeit bekannten Vorrichtungen bzw. Verfahren umgeht.

In der vorliegenden Erfindung beruht die Frequenzmessung eines Signals grundsätzlich auf der Messung der Signalphase zu verschiedenen Zeitpunkten. Es werden dabei jeweils zwei unabhängige Signalphasenmessungen und die zeitliche Differenz für die Frequenzbestimmung wie folgt herangezogen:

$$F_{ik} = (\varphi_i - \varphi_k)/ t_{ik} \qquad (1)$$

wobei $\varphi_i$ die Phase zum Zeitpunkt i, $\varphi_k$ die Phase zum Zeitpunkt k, und $t_{ik}$ die zeitliche Differenz zwischen den Phasen $\varphi_i$ und $\varphi_k$ darstellt.

Es sei bemerkt, daß die Phase $\varphi_i$ nicht bei 360° endet, sondern, auf einen relativen Zeitpunkt bezogen, absolut gemessen wird. Jede weitere Messung derselben Signalquelle, die während der Messung in ihrer Signalfrequenz konstant bleiben muß, ist eine unabhängige Messung. Für den Fehler und für den Mittelwert Fm von n Messungen gilt die Beziehung:

$$F_m = \Sigma_n F_{ik}/n \qquad (2)$$

Dabei nimmt der Fehler mit der Wurzel aus n zu.

Erfindungsgemäß wird die Phase $\varphi$ in einem Zeitraum t in äquidistanten zeitlichen Abständen gemessen. Die Messung beginnt mit dem Zeitpunkt t0 und die zeitlichen Abstände betragen dt. Bei 2*n Meßwerten ergibt sich eine gesamte Zeit t von dt(2*n -1).

Zur einfacheren Berechnung werden jeweils ein Paar der Meßwerte mit Abstand n*dt für die Frequenzbestimmung herangezogen.

$$F_i = (\varphi_{n+i} - \varphi_i) / dt*n \qquad \text{für i = 1, 2, 3} \qquad (3)$$

wobei $\varphi_{n+i}$ die Phase zum Zeitpunkt n+i, $\varphi_i$ die Phase zum Zeitpunkt i, und dt*n die zeitliche Differenz zwischen den Phasen $\varphi_{n+1}$ und $\varphi_i$ darstellt.

Für diese Frequenzen kann nun der Mittelwert analog zur Gleichung (2) wie folgt bestimmt werden:

$$F = \Sigma_n \ F_i/n \qquad (4)$$

Durch die nicht kohärente Integration bzw. Summation findet eine mit der Wurzel aus n zunehmende Steigerung der Genauigkeit statt.

Werden die oberen Gleichungen nun im binären System gelöst, so kann die Division für schnelle Prozesse problematisch sein. Hierbei kann in diesem Fall nach einem vorteilhaften Aspekt der Erfindung durch 2n dividiert werden, was einer einfachen Schiebeoperation entspricht. Für einfache Lösungsberechnungen werden zweckmäßigerweise Zahlen n in Höhe einer Zweierpotenz genommen.

Beim Einsetzen der Gleichung (3) in die Gleichung (4) berechnet sich der Frequenzmittelwert F wie folgt aus:

$$F = (1/(n*dt*n)) * (\varphi_{n+1} - \varphi_1 + \varphi_{n+2} - \varphi_2 + ... +$$

$$\varphi_{n+n} - \varphi_n) \qquad (5)$$

Alternativ kann die Gleichung (5) des Frequenzmittelwerts wie folgt errechnet werden:

$$F = (1/(n*dt*n)) * (\Sigma_n \varphi_{n+i} - \Sigma_n \varphi_i) \qquad (6)$$

Bei der Erweiterung der Summanden in der Gleichung (6) um $\Sigma_n \varphi_i$ ergibt sich die folgende Gleichung des Frequenzmittelwerts:

$$F = (1/(n*dt*n)) * (\Sigma_{2*n} \varphi_i - 2\Sigma_n \varphi_i) \qquad (7)$$

Damit ergibt sich eine gemittelte Frequenzmessung F über 2n äquidistante Meßwerte als Ergebnis aus der Summe aller Meßwerte minus der doppelten Summe der ersten Hälfte der Meßwerte geteilt durch n und geteilt durch dt*(n-1), der Zeitbasis der Einzelfrequenzmessung.

Der besondere Vorteil dieser Art von Frequenzmessung ist die sequentielle Meßwertverarbeitungsmöglichkeit mit einem Integrator (Summierer), einem Zwischenspeicher, einem einfachen Links-Shift-Multiplizierer, einem Subtrahierer und einem Rechts-Shift-Dividierer.

Die Fig. 1 zeigt den einfachen sequentiellen Ablauf der Meßwertverarbeitung. Die Messung wird mit dem Trigger 1 gestartet und der Phasenakkumulator 2 wird anschließend mit dem ersten Phasenwert 3 geladen. Danach werden durch den Phasenakkumulator 2 alle weiteren Phasenwerte 3 mit jedem Takt 4, der von einer nicht gezeigten Taktschaltung ausgegeben wird, vorzeichenrichtig aufaddiert bzw. aufintegriert. Es gibt keine Einschränkung für das Vorzeichen der Phase, sie muß jedoch eindeutig sein und darf nicht als Modulo von 360 Grad gebildet werden.

Nach $2^k$ * dt Takten und dementsprechend $2^k$

Phasenwerten wird die vom Phasenakkumulator 2 ausgegebene Phasensumme in ein erstes Zwischenregisters 6 übernommen und gleichzeitig dieser Wert mit dem Faktor 2 multipliziert und in ein zweites Zwischenregister 7 übernommen. Somit wird das zweite Glied $(2\Sigma_n\varphi_i)$ der Differenz in der Gleichung (7) erhalten.

Nach dem Ablauf von weiteren $2^k * dt$ Takten bzw. von $2^k$ Phasenmeßwertsummationen wird der im zweiten Zwischenregister 7 gespeicherte Wert vom neuen Summenwert des ersten Zwischenregister 6, der nunmehr einer Gesamtzahl von $2 * 2^k$ Phasenmeßwertsummationen und somit dem ersten Glied $(\Sigma_2*_n\varphi_i)$ der Differenz der Gleichung (7) entspricht, in einen Subtrahierer 8 subtrahiert und dann in einem Dividierer durch $2^k * 2^k$ dividiert. Vorteilhaft erfolgt diese Division durch $2^k * 2^k$, indem das Ergebnis der Subtraktion um 2k Stellen nach links verschoben wird. Das Ergebnis wird im Ausgangsregister 9 abgelegt und es entspricht einem Wert der Signalfrequenz bezogen auf *dt, der direkt proportional zur Signalfrequenz F ist.

Der wesentliche Vorteil der vorliegenden Erfindung besteht in der sehr einfachen Ausführbarkeit der Berechnung, die sich strukturell auch gut in einem ASIC implementieren läßt. Die Anwendung der Erfindung findet idealerweise im Bereich digitaler IFMs, digitalen Receivern und digitalen Frequenzmeßgeräten statt.

Mit dem erfindungsgemäßen Verfahren bzw. der erfindungsgemäßen Vorrichtung können sowohl hochfrequente, als auch niederfrequente Signalfrequenzen auf einfache Weise digital detektiert werden. Insbesondere läßt sich das Verfahren auch gut durch Single Chip Asics realisieren, was die Einsetzbarkeit in Receivern und ähnlichen Geräten vorteilhaft gestaltet.

Wenn technische Merkmale in den Ansprüchen mit Bezugszeichen versehen sind, so sind diese Bezugszeichen lediglich zum besseren Verständnis der Ansprüche vorhanden. Dementsprechend stellen solche Bezugszeichen keine Einschränkungen des Schutzumfangs solcher Elemente dar, die nur exemplarisch durch solche Bezugszeichen gekennzeichnet sind.

**Patentansprüche**

1. Vorrichtung zur Frequenzmessung mit Integration der Signalphase, die folgendes umfaßt:

   - einen Phasenakkumulator (2), mit dem die Signalphase eines Signals, dessen Frequenz bestimmt werden soll, in vorbestimmten Zeitintervallen aufintegriert wird;

   - ein erster Zwischenspeicher (6), der steuerbar ist, um nach einer vorbestimmten ersten Anzahl von Zeitintervallen nach Start der Frequenzmessung einen ersten Ausgangswert des Phasenakkumulators (2) zu übernehmen, und der weiterhin steuerbar ist, um nach einer zweiten Anzahl von Zeitintervallen nach Start der Frequenzmessung einen zweiten Ausgangswert des Phasenakkumulators (2) zu übernehmen, wobei die zweite Anzahl von Zeitintervallen dem Doppelten der ersten Anzahl von Zeitintervallen entspricht;

   - ein zweiter Zwischenspeicher (7), der ausgebildet ist, um den ersten Ausgangswert des ersten Zwischenspeichers (6) zu übernehmen und mit einem ersten Faktor zu multiplizieren, der dem Quotient der zweiten Anzahl von Zeitintervallen und der ersten Anzahl von Zeitintervallen entspricht, und auf einen wert von 2 festgelegt ist;

   - ein Subtrahierer (8), der ausgebildet ist, um vom zweiten Ausgangswert den mit dem ersten Faktor multiplizierten ersten Ausgangswert zu subtrahieren; und

   - ein Dividierer , der ausgebildet ist, den Ausgangswert des Subtrahierers (8) durch einen zweiten Faktor zu teilen, der dem Produkt der ersten Anzahl von Zeitintervallen mit der Differenz der zweiten Anzahl von Zeitintervallen und der ersten Anzahl von Zeitintervallen entspricht,

   - wobei der Ausgangswert des Dividierers einen Wert annimmt, der proportional zur zu messenden Frequenz ist.

2. Vorrichtung nach Anspruch 1, die weiterhin eine einen Takt (4) erzeugende Taktschaltung umfaßt, die den Phasenakkumulator (2) derart ansteuert, daß alle Zeitintervalle gleich sind.

3. Vorrichtung nach Anspruch 1 oder 2, wobei der Dividierer als Schieberegister ausgebildet ist und wobei die erste Anzahl von Zeitintervallen $2^k$ beträgt und die zweite Anzahl von Zeitintervallen $2 * 2^k$ beträgt, mit k gleich einer natürlichen Zahl.

4. Vorrichtung nach einem oder mehreren der Ansprüche 1-3, die weiterhin ein Ausgangsregister (9) zum Festhalten und zur Ausgabe des Ausgangswerts des Dividierers umfaßt.

5. Vorrichtung nach einem oder mehreren der Ansprüche 2-4, die weiterhin Mittel umfaßt, um den Ausgangswert des Dividierers durch das Zeitintervall zu dividieren, um die zu messende Frequenz zu erhalten.

6. Verfahren zur Frequenzmessung mit Integration der Signalphase, das die folgenden Schritte umfaßt:

- das Aufintegrieren in vorbestimmten Zeitintervallen der Signalphase eines Signals, dessen Frequenz bestimmt werden soll;

- das erste Zwischenspeichern der aufintegrierten Signalphase nach einer vorbestimmten ersten Anzahl von Zeitintervallen nach Start der Frequenzmessung, um einen ersten Ausgangswert zu erhalten;

- das zweite Zwischenspeichern der aufintegrierten Signalphase nach einer zweiten Anzahl von Zeitintervallen nach Start der Frequenzmessung, um einen zweiten Ausgangswert zu erhalten, wobei die zweite Anzahl von Zeitintervallen dem Doppelten der ersten Anzahl von Zeitintervallen entspricht;

- das Multiplizieren des ersten Ausgangswerts mit einem ersten Faktor, der dem Quotient der zweiten Anzahl von Zeitintervallen und der ersten Anzahl von Zeitintervallen entspricht, und auf einen wert von 2 fertgelegt ist;

- das Subtrahieren des mit dem ersten Faktor multiplizierten ersten Ausgangswerts vom zweiten Ausgangswert, um einen dritten Ausgangswert zu erhalten; und

- das Dividieren des dritten Ausgangswerts durch einen zweiten Faktor, der dem Produkt der ersten Anzahl von Zeitintervallen mit der Differenz der zweiten Anzahl von Zeitintervallen und der ersten Anzahl von Zeitintervallen entspricht, um einen vierten Ausgangswert zu erhalten;

- wobei der vierte Ausgangswert einen Wert annimmt, der proportional zur zu messenden Frequenz ist.

**7.** Verfahren nach Anspruch 6, wobei alle Zeitintervalle gleich sind.

**8.** Verfahren nach Anspruch 7 oder 8, wobei die erste Anzahl von Zeitintervallen $2^k$ beträgt und die zweite Anzahl von Zeitintervallen $2 * 2^k$ beträgt, mit k gleich einer natürlichen Zahl und wobei das Dividieren durch die Verschiebung des dritten Ausgangswerts um $2 * k$ Stellen in einem Schieberegister erfolgt.

**9.** Verfahren nach einem oder mehreren der Ansprüche 7-8, das weiterhin einen Schritt umfaßt, um den vierten Ausgangswert durch das Zeitintervall zu dividieren, um die zu messende Frequenz zu erhalten.

**Claims**

**1.** Apparatus for frequency measurement with integration of the signal phase, which comprises the following:

- a phase accumulator (2), by means of which the signal phase of a signal whose frequency is intended to be determined is integrated at predetermined time intervals;

- a first buffer store (6), which is controllable, in order to transfer a first output value from the phase accumulator (2) after a predetermined first number of time intervals from the start of the frequency measurement, and which is also controllable in order to transfer a second output value from the phase accumulator (2) after a second number of time intervals from the start of the frequency measurement, with the second number of time intervals corresponding to twice the first number of time intervals;

- a second buffer store (7), which is designed in order to transfer the first output value from the first buffer store (6) and to multiply by a first factor, which corresponds to the quotient of the second number of time intervals and the first number of time intervals, and is fixed at a value of 2;

- a subtractor (8) which is designed in order to subtract the first output value, multiplied by the first factor, from the second output value; and

- a divider, which is designed to divide the output value from the subtractor (8) by a second factor, which corresponds to the product of the first number of time intervals and the difference between the second number of time intervals and the first number of time intervals,

- with the output value from the divider assuming a value which is proportional to the frequency to be measured.

**2.** Apparatus according to Claim 1, which also has a clock circuit, which produces a clock (4) and drives the phase accumulator (2) in such a way that all the time intervals are the same.

**3.** Apparatus according to Claim 1 or 2, with the divider being designed as a shift register, and with the first number of time intervals being $2^k$, and the second number of time intervals being $2 * 2^k$, where k is equal to a natural number.

**4.** Apparatus according to one or more of Claims 1-3, which also has an output register (9) for holding and for emitting the output value from the divider.

5. Apparatus according to one or more of Claims 2-4, which also has means in order to divide the output value from the divider by the time interval, in order to obtain the frequency to be measured.

6. Method for frequency measurement with integration of the signal phase, which comprises the following steps:

   - integration at predetermined time intervals of the signal phase of a signal whose frequency is intended to be determined;

   - first buffer storage of the integrated signal phase after a predetermined first number of time intervals from the start of the frequency measurement, in order to obtain a first output value;

   - second buffer storage of the integrated signal phase after a second number of time intervals from the start of the frequency measurement, in order to obtain a second output value, with the second number of time intervals corresponding to twice the first number of time intervals;

   - multiplication of the first output value by a first factor, which corresponds to the quotient of the second number of time intervals and the first number of time intervals, and which is fixed at a value of 2;

   - subtraction of the first output value, multiplied by the first factor, from the second output value, in order to obtain a third output value; and

   - division of the third output value by a second factor, which corresponds to the product of the first number of time intervals and the difference between the second number of time intervals and the first number of time intervals, in order to obtain a fourth output value;

   - with the fourth output value assuming a value which is proportional to the frequency to be measured.

7. Method according to Claim 6, with all of the time intervals being the same.

8. Method according to Claim 7 or 8, with the first number of time intervals being $2^k$ and the second number of time intervals being $2 * 2^k$, where k is equal to a natural number, and with the division being carried out by shifting the third output value through 2 * k positions in a shift register.

9. Method according to one or more of Claims 7-8, which also includes a step of dividing the fourth output value by the time interval, in order to obtain the frequency to be measured.

## Revendications

1. Dispositif de mesure de fréquence avec intégration de phase de signal, qui comprend les composants suivants:

   - un accumulateur de phase (2), avec lequel la phase de signal d'un signal, dont la fréquence doit être déterminée, est intégrée dans des intervalles de temps prédéterminés;

   - une première mémoire intermédiaire (6), qui peut être commandée pour reprendre une première valeur initiale de l'accumulateur de phase (2) après un premier nombre prédéterminé d'intervalles de temps après le démarrage de la mesure de fréquence, et qui peut en outre être commandée pour reprendre une deuxième valeur initiale de l'accumulateur de phase (2) après un deuxième nombre d'intervalles de temps après le démarrage de la mesure de fréquence, le deuxième nombre d'intervalles de temps correspondant au double du premier nombre d'intervalles de temps;

   - une deuxième mémoire intermédiaire (7), qui est configurée pour reprendre la première valeur initiale de la première mémoire intermédiaire (6) et la multiplier par un premier facteur, qui correspond au quotient du deuxième nombre des intervalles de temps et du premier nombre des intervalles de temps, et qui est fixé à une valeur de 2;

   - un soustracteur (8), qui est configuré pour soustraire de la deuxième valeur initiale la première valeur initiale multipliée par le premier facteur; et

   - un diviseur, qui est configuré pour diviser la valeur initiale du soustracteur (8) par un deuxième facteur, qui correspond au produit du premier nombre d'intervalles de temps par la différence entre le deuxième nombre d'intervalles de temps et le premier nombre d'intervalles de temps,

   - dans lequel la valeur initiale du diviseur prend une valeur qui est proportionnelle à la fréquence à mesurer.

2. Dispositif selon la revendication 1, qui comprend en outre un circuit de synchronisation produisant une cadence (4), qui commande l'accumulateur de phase (2) de telle façon que tous les intervalles de temps soient égaux.

3. Dispositif selon la revendication 1 ou 2, dans lequel le diviseur est configuré en registre à décalage et dans lequel le premier nombre d'intervalles de temps vaut $2^k$ et le deuxième nombre d'intervalles de temps vaut $2*2^k$, k étant égal à un nombre naturel.

4. Dispositif selon une ou plusieurs des revendications 1 à 3, qui comprend en outre un registre de sortie (9) pour fixer et pour produire la valeur initiale du diviseur.

5. Dispositif selon une ou plusieurs des revendications 2 à 4, qui comprend en outre des moyens pour diviser la valeur initiale du diviseur par l'intervalle de temps, pour obtenir la fréquence à mesurer.

6. Procédé de mesure de fréquence avec intégration de la phase de signal, qui comprend les étapes suivantes:

   - l'intégration, dans des intervalles de temps prédéterminés, de la phase de signal d'un signal dont la fréquence doit être déterminée;
   - la première mémorisation intermédiaire de la phase de signal intégrée après un premier nombre prédéterminé d'intervalles de temps après le démarrage de la mesure de fréquence, pour obtenir une première valeur initiale;
   - la deuxième mémorisation intermédiaire de la phase de signal intégrée après un deuxième nombre d'intervalles de temps après le démarrage de la mesure de fréquence, pour obtenir une deuxième valeur initiale, le deuxième nombre d'intervalles de temps correspondant au double du premier nombre d'intervalles de temps;
   - la multiplication de la première valeur initiale par un premier facteur, qui correspond au quotient du deuxième nombre d'intervalles de temps et du premier nombre d'intervalles de temps et qui est fixé à une valeur de 2;
   - la soustraction de la première valeur initiale multipliée par le premier facteur de la deuxième valeur initiale, pour obtenir une troisième valeur initiale; et
   - la division de la troisième valeur initiale par un deuxième facteur, qui correspond au produit du premier nombre d'intervalles de temps par la différence entre le deuxième nombre d'intervalles de temps et le premier nombre d'intervalles de temps, pour obtenir une quatrième valeur initiale;
   - dans lequel la quatrième valeur initiale prend une valeur qui est proportionnelle à la fréquence à mesurer.

7. Procédé selon la revendication 6, dans lequel tous les intervalles de temps sont égaux.

8. Procédé selon la revendication 6 ou 7, dans lequel le premier nombre d'intervalles de temps vaut $2^k$ et le deuxième nombre d'intervalles de temps vaut $2*2^k$, k étant égal à un nombre naturel, et dans lequel la division est effectuée par le glissement de la troisième valeur initiale de $2*k$ positions dans un registre à décalage.

9. Procédé selon une ou plusieurs des revendications 7 et 8, qui comprend en outre une étape pour diviser la quatrième valeur initiale par l'intervalle de temps, afin d'obtenir la fréquence à mesurer.

Fig. 1